(19) Europäisches Patentamt

European Patent Office

Office européen des brevets

(11) **EP 1 278 094 B1**

(12) **EUROPÄISCHE PATENTSCHRIFT**

(45) Veröffentlichungstag und Bekanntmachung des Hinweises auf die Patenterteilung:
**05.10.2005 Patentblatt 2005/40**

(51) Int Cl.⁷: **G02B 27/14**, C23C 14/56, C23C 14/22

(21) Anmeldenummer: **02015747.5**

(22) Anmeldetag: **13.07.2002**

(54) **Geometrischer Strahlteiler und Verfahren zu seiner Herstellung**

Geometrical beamsplitter and method for manufacturing the same

Séparateur de faisceau géométrique et son procédé de production

(84) Benannte Vertragsstaaten:
**DE GB NL**

(30) Priorität: **17.07.2001 DE 10136507**

(43) Veröffentlichungstag der Anmeldung:
**22.01.2003 Patentblatt 2003/04**

(73) Patentinhaber: **Carl Zeiss SMT AG**
**73446 Oberkochen (DE)**

(72) Erfinder:
• **Heller, Matthias**
**35644 Hohenahr (DE)**
• **Kress, Werner**
**35578 Wetzlar (DE)**
• **Kuhn, Matthias**
**73563 Moegglingen (DE)**
• **Weissenrieder, Stefan**
**73430 Aalen (DE)**

(74) Vertreter: **Patentanwälte**
**Ruff, Wilhelm, Beier, Dauster & Partner**
**Kronenstrasse 30**
**70174 Stuttgart (DE)**

(56) Entgegenhaltungen:
**WO-A-97/31298** **WO-A-97/44155**
**US-A- 1 253 138**

• **PATENT ABSTRACTS OF JAPAN vol. 012, no. 348 (E-659), 19. September 1988 (1988-09-19) & JP 63 107082 A (MITSUBISHI ELECTRIC CORP), 12. Mai 1988 (1988-05-12)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Herstellung eines geometrischen Strahlteilers, einen mit Hilfe des Verfahrens herstellbaren Strahlteiler sowie ein mit einem derartigen Strahlteiler ausgestattetes Beleuchtungssystem für eine optische Einrichtung, insbesondere eine Mikrolithographie-Projektionsbelichtungsanlage.

In zahlreichen Anwendungsgebieten der Optik ist es erforderlich, einen Lichtstrom in zwei gleiche oder ungleiche Teilströme aufzuteilen. Hierzu werden Strahlteiler eingesetzt, die entweder als geometrische Strahlteiler oder als physikalische Strahlteiler ausgebildet sind. Während die physikalische Strahlteilung den Bündelquerschnitt des Lichtstromes ungeändert lässt, findet bei geometrischer Strahlteilung die Aufteilung eines Bündelquerschnittes in Teilbündel statt, beispielsweise mit Hilfe einer reflektierenden Fläche, die Durchbrechungen aufweist.

Bei vielen Anwendungen wird angestrebt, das Verhältnis zwischen reflektierter Energie und durch die Durchbrechungen transmittierter Energie genau zu kennen, beispielsweise bei sogenannten Dosimetriespiegeln, wie sie in Beleuchtungssystemen für optische Einrichtungen eingesetzt werden.

Als ein Beispiel zeigt die US 6,028,660 ein mit einer Dosimetrieeinrichtung ausgestattetes Beleuchtungssystem für eine Mikrolithographie-Projektionsbelichtungsanlage zur Herstellung von Halbleiterbauelementen und anderen feinstrukturierten Bauteilen. Derartige Anlagen, die als Wafer-Scanner oder Wafer-Stepper ausgebildet sein können, dienen dazu, Muster von Fotomasken (Retikel) oder Strichplatten auf einen mit einer lichtempfindlichen Schicht beschichteten Gegenstand, beispielsweise einen Halbleiterwafer, mit höchster Auflösung zu projizieren. Um auf dem Substrat ein wohldefiniertes Muster zu erhalten, sollte das Substrat mit einer genau bestimmten Energiemenge, bzw. Dosis bestrahlt werden. Es ist daher wichtig, die tatsächliche Bestrahlungsdosis genau zu bestimmen, um gegebenenfalls die geforderte Dosis mit Hilfe einer Rückkopplungseinrichtung zur Steuerung der Beleuchtungsstärke der Lichtquelle genau einstellen zu können. Zur Messung der Beleuchtungsenergie hat das Beleuchtungssystem zwischen seiner Lichtquelle und seinem Lichtaustritt eine Auskoppeleinrichtung zur Auskopplung eines Bruchteiles der von der Lichtquelle kommenden Lichtenergie in Richtung eines Energiesensors, dessen Messwert zur Steuerung der Lichtquelle dienen kann. Dabei ist es wichtig, den Absolutwert der Transmission des Strahlteilers zu kennen, um aufgrund des Energiemesswertes des Energiesensors auf den Absolutwert der Bestrahlungsstärke der Lichtquelle schließen zu können. Dies ist beispielsweise bei Wafer-Steppern erforderlich, um die Verschlusszeit bzw. die Beleuchtungsdauer einer Belichtung genau einstellen zu können. Bei Wafer-Scannern ist es wichtig, dass die Beleuchtungsdosis innerhalb des gleichen Beleuchtungsfeldes einheitlich ist.

Es besteht daher ein Bedarf nach Strahlteilern mit genau definierbarer Transmission. Diese sollten auf einfache und kostengünstige Weise herstellbar sein.

Der Erfindung liegt die Aufgabe zugrunde, ein Verfahren zur Herstellung eines geometrischen Strahlteilers zu schaffen, mit dem auf kostengünstige Weise geometrische Strahlteiler mit genau definiertem Transmissionsgrad herstellbar sind. Weiterhin ist es Aufgabe, einen geometrischen Strahlteiler mit genau definierbarem Transmissionsgrad zu schaffen, der kostengünstig in großen Stückzahlen herstellbar ist.

Zur Lösung dieser Aufgabe schlägt die Erfindung ein Verfahren mit den Merkmalen von Anspruch 1 bzw. einen geometrischen Strahlenteiler mit den Merkmalen von Anspruch 6 vor.

Bei dem erfindungsgemäßen Verfahren wird zunächst eine Oberfläche eines aus transparentem Material bestehenden Substrates mit einer Reflexbeschichtung beschichtet, die mindestens eine Metallschicht enthält. Deren Dicke ist vorzugsweise so gewählt, dass sie im wesentlichen undurchlässig für das zur Bestrahlung vorgesehene Licht ist. Anschließend wird in der Reflexbeschichtung eine Lochstruktur mit einer Vielzahl von transparenten Löchern erzeugt, deren Anzahl, Größe und/oder Verteilung den Transmissionsgrad des Strahlteilers wesentlich bestimmt. Die Löcher werden erfindungsgemäß durch Laserbearbeitung hergestellt. Hierbei wird die Reflexbeschichtung zur Erzeugung von transparenten Durchbrechungen in der Reflexschicht an vielen Stellen gleichzeitig oder nacheinander derart mit Laserlicht geeigneten Durchmessers und geeigneter Wellenlänge, Energie und Dauer bestrahlt, dass ohne Zerstörung des Substrates oder an den Beteuchtungsort angrenzender Bereiche der Reflexbeschichtung lichtdurchlässige Löcher in der Reflexbeschichtung entstehen. Die Gesamttransmission ist im wesentlichen über die Anzahl der Löcher und deren mittlere Flächen einstellbar.

Weiterhin ist gemäß der Erfindung vorgesehen, dass eine Lochstruktur mit einer statistischen Verteilung von Löchern erzeugt wird, also eine Nicht-Gitterstruktur, bei der die Flächenkoordinaten der einzelnen Löcher nach dem Zufallsprinzip erzeugt werden. Vorzugsweise liegen alle Löcher in statistischer Verteilung vor. Es kann aber auch eine Gruppe statistisch verteilter Löcher zusätzlich zu einer Gruppe regelmäßig verteilter Löcher vorgesehen sein.

Statistische Lochverteilungen haben sowohl bei der Herstellung, als auch im Einsatz des Strahlteilers erhebliche Vorteile. Im Einsatz des Strahlteilers, d.h. bei großflächiger Beleuchtung der Spiegelfläche, werden Beugungseffekte und Interferenzeffekte im transmittierten Licht, wie sie bei einer regelmäßigen Gitterstruktur von Transmissionslöchern entstehen können, vermieden. Außerdem lassen sich statistische Lochmuster besonders einfach durch Erzeugung weiterer (statistisch verteilter) Löcher zu gleichfalls wieder statistischen Lochmustern größerer Gesamttransmission ergänzen. Im folgenden wird erläutert, wie bei Nutzung statistischer Lochmuster mit hoher Gutausbeute Strahlteiler mit genau vorgegebenem Transmissionsgrad herstellbar sind.

Das Verfahren ist für alle Reflexbeschichtungen geeignet, die für die bei der Strukturierung verwendete Laserwellenlänge eine genügend hohe Absorption haben, um die Reflexbeschichtung, im wesentlichen durch Verdampfung, zu beseitigen. In diesem Sinne steht der Begriff "Metallschicht" allgemein für Schichten aus Materialien, die das Bearbeitungslicht ausreichend stark absorbieren, um eine Verdampfung zu bewirken. Derartige Materialien können auch nicht metallisch sein. Gegenüber nasschemischen Ätzverfahren, bei denen die Lochstruktur mittels eines photolithographischen Prozesses mit Beschichtung, Belichtung und anschließender Ätzung erzeugt werden kann, hat die trockene Laserstrukturierung den Vorteil, dass an der Spiegelfläche keine chemischen Veränderungen oder Kontaminationen verursacht werden. Das Verfahren arbeitet sowohl in Vakuum, als auch an Luft, es stellt also keine besonderen Anforderungen an die Arbeitsumgebung. Es können kostengünstig und schnell geometrische Strahlteiler wohldefinierten Transmissionsgrades hergestellt werden.

Vorzugsweise wird zur Lochbildung ein gepulster Laser verwendet. Es hat sich als vorteilhaft herausgestellt, wenn ein erster und mindestens ein zweiter Laserpuls auf den gleichen Bereich eingestrahlt werden, wobei die Laserenergie vorzugsweise so eingestellt ist, dass der erste Laserpuls im wesentlichen das Loch in der Beschichtung erzeugt und mit dem zweiten noch eine Reinigung des Loches zur Glättung und Vergleichmäßigung der Lochrandstruktur durchgeführt wird. Es hat sich gezeigt, dass es ausreichend ist, wenn die Laserpulse im wesentlichen die gleiche Leistungsdichte und Dauer haben, so dass an die Steuerung des Lasers bei der Laserbearbeitung keine besonderen Anforderungen gestellt werden und das Verfahren kostengünstiger durchführbar ist, als beispielsweise bekannte Verfahren zur zielgenauen Erzeugung von Blind- und Durchgangslöchern in mehrlagigen Strukturen für Multichip-Module (WO 97/44155).

Bei einer Weiterbildung des Verfahrens wird zur Herstellung eines Strahlteilers mit vorgegebenem Transmissions-Sollwert zunächst gezielt gesteuert eine Verteilung von Löchern derart erzeugt, dass der Transmissionsgrad des Strahlteilers geringer ist als der Transmissions-Sollwert, beispielsweise um 10%-20% niedriger liegt als dieser Sollwert. Diese im ersten Schritt erzeugte Ausgangsverteilung kann regelmäßig sein, ist jedoch bevorzugt eine statistische Lochverteilung. Anschließend wird eine Messung des Transmissionsgrades des Strahlteilers zur Bestimmung eines Transmissionsistwertes durchgeführt. In Abhängigkeit von dem Transmission-Istwert werden dann weitere, vorzugsweise irregulär bzw. statistisch verteilte Löcher zur kontrollierten Erhöhung des Transmissionsgrades bis hin zum angestrebten Transmission-Sollwert erzeugt. Es wird also ein mehrstufiges Verfahren durchgeführt, bei dem der Transmissionsgrad schrittweise an den angestrebten Sollwert herangeführt wird. Dabei können die Schritte der Messung des Sollwertes und der nachfolgenden Erzeugung weiterer Löcher, gegebenenfalls mehrfach, wiederholt werden, um sich auf diese Weise an dem Transmissionsgrad-Sollwert "heranzutasten". Auf diese Weise ist eine hohe Gutausbeute von Strahlteilern erzielbar, da eine ungewollte Erzeugung von Strahlteilern mit zu hohem Transmissionsgrad zuverlässig vermieden wird.

Die Erzeugung weiterer Löcher kann nach dem "trial-and-error"-Prinzip erfolgen. Vorzugsweise wird jedoch nach der Messung des Istwertes des Transmissionsgrades eine Berechnung der Anzahl noch zu erzeugender Löcher auf Basis der Differenz zwischen Transmissions-Sollwert- und Istwert durchgeführt, so dass eine vorherberechnete Anzahl neuer Löcher hinzugefügt werden kann, um gegebenenfalls in einem Schritt den Transmissions-Sollwert mit hoher Genauigkeit zu erreichen. Bei einer anderen Verfahrensvariante wird eine in-situ-Messung der Transmission während der Strukturierung der Spiegel durchgeführt. Die Erzeugung weiter Löcher kann dann in Abhängigkeit des Messergebnisses dieser Messung erfolgen. Damit kann die erzielbare Genauigkeit der Transmissionseinstellung auf den Transmissionsbeitrag eines einzelnen Loches eingestellt werden.

Vorzugsweise haben die erfindungsgemäß hergestellten Löcher mittlere Durchmesser zwischen ca. 30μm und ca. 100μm, insbesondere zwischen ca. 40μm und ca. 60μm. Die mittleren Lochabstände betragen normalerweise zwischen ca. 0,5mm und ca. 1mm. Insbesondere für Strahlteiler für die bevorzugte Anwendung im Beleuchtungssystem von mikrolithographischen Projektionsanlagen sind niedrige Transmissionsgrade von weniger als ca. 5% bevorzugt, damit der überwiegende Teil des Lichtes zur Erzielung hoher Durchsatzraten von belichteten Substraten genutzt werden kann. Praktisch sollte der Transmissionsgrad unterhalb von 3% liegen, insbesondere im Bereich von ca. 1%. Bezogen auf den Absolutbetrag des Transmissions-Sollwertes können Genauigkeiten von besser als 30% regelmäßig erreicht werden.

Für die mindestens eine Metallschicht kann jedes geeignete metallische Material als Reinmaterial oder Legierung verwendet werden, sofern dessen Reflexionsgrad für die im Betrieb auftreffende elektromagnetische Strahlung ausreichend hoch ist. Für bevorzugte Anwendungen bei Dosimetriespiegeln in Beleuchtungssystemen für mit Ultraviolettlicht arbeitende mikrolithographischen Anlagen wird Aluminium bevorzugt, weil dessen Reflexionsgrad in einem relevanten Einfallswinkelbereich zwischen ca. 30° und ca. 60° relativ unabhängig vom Auftreffwinkel der einfallenden Strahlung ist. Schichtdicken können beispielsweise im Bereich zwischen ca. 50nm und ca. 100nm liegen, sind jedoch nicht auf diesen Bereich beschränkt.

Gute Ultraviolett-Verspiegelungen auf Basis von Aluminium können im Aufdampfverfahren bei geringen Umgebungsdrücken und hohen Aufdampfraten erzielt werden, beispielsweise mit einer Flash-Verdampfung. Optimale Herstellungsbedingungen sind jedoch in der Produktion nur mit hohem technischen Aufwand reproduzierbar zu gestalten. Eine bevorzugte Variante eines erfindungsgemäßen Verfahrens zur Herstellung einer Verspiegelungsschicht sieht vor, das Material der Metallschicht, insbesondere also Aluminium, mit einer ansteigenden Aufdampfrate aufzudampfen. Dabei werden zu Beginn der Aufdampfung relativ niedrige Aufdampfraten gewählt. Die Aufdampfrate wird dann, vorzugsweise linear, bis zu hohen Aufdampfraten gesteigert. Auf diese Weise lassen sich ohne großen technischen Aufwand Verspiegelungen hoher Güte, insbesondere mit Aluminium, herstellen. Bei dieser Verfahrensvariante setzt man das zu verdampfende Material, insbesondere Aluminium, zunächst nach Art einer Getterpumpe ein, um einen geringen Druck im Rezipienten der Bedampfungsanlage zu erreichen. Entsprechend sind die anfänglich niedrigen Aufdampfraten einzustellen. Anschließend wird mit hohen Aufdampfraten in gereinigter Atmosphäre weitgehend verunreinigungsfreies Aluminium aufgedampft, welches die Reflexionsfläche bildet. Diese Verfahrensvariante mit steigender Aufdampfrate kann bei allen Verspiegelungsverfahren mit Vorteil eingesetzt werden, auch wenn in der Reflexbeschichtung keine Lochstruktur erzeugt wird.

Die Reflexionsbeschichtung kann ausschließlich aus einer Metallschicht bestehen. Vorzugsweise wird jedoch auf die metallische Schicht mindestens eine Schicht aus dielektrischem Material aufgebracht. Diese kann beispielsweise vorwiegend eine Schutzfunktion ausüben, ist jedoch vorzugsweise als Reflexionsverstärkungsschicht ausgebildet. Bevorzugt wird auf die Metallschicht ein Mehrschichtsystem mit mehreren Schichten aus abwechselnd niedrigbrechendem und hochbrechendem dielektrischen Material aufgebracht. Derartige Reflexbeschichtungen sind beispielsweise aus der EP 0 280 299 (entsprechend US 4,856,019), der US 4,714,308, der EP 0 939 467 oder der US 5,850,309 bekannt. Sämtliche darin beschriebenen Schichtsysteme sind prinzipiell zur Herstellung erfindungsgemäßer Strahlungsteiler geeignet.

Bevorzugte Schichtsysteme für die Reflexbeschichtung erfindungsgemäßer Strahlteiler werden im Zusammenhang mit den Ausführungsbeispielen näher erläutert. Sie können selbstverständlich auch unabhängig von einer eingebrachten Lochstruktur bei der Herstellung hochreflektierender Spiegel für Ultra-violettlicht aus dem Wellenlängenbereich zwischen ca. 193nm und ca. 365nm verwendet werden.

Die Efindung wird in den angefügten Ansprüchen definiert.

Fig. 1: eine schematische Darstellung einer Mikrolithographie- Projektionsbelichtungsanlage mit einem Beleuchtungssystem, welches einen erfindungsgemäßen Strahlteiler enthält;

Fig. 2: einen schematischen Schnitt durch eine Ausführungsform eines erfindungsgemäßen Strahlteilers;

Fig. 3: eine schematische Draufsicht auf eine bevorzugte Ausführungsform eines erfindungsgemäßen Strahlteilers;

Fig. 4: Reflexionsgrad der für 365nm vorgesehenen Reflexschicht mit breitem Stopband als Funktion der Wellenlänge

Fig. 5: Reflexionsgrad dieser Beschichtung als Funktion des Inzidenzwinkels um 45°.

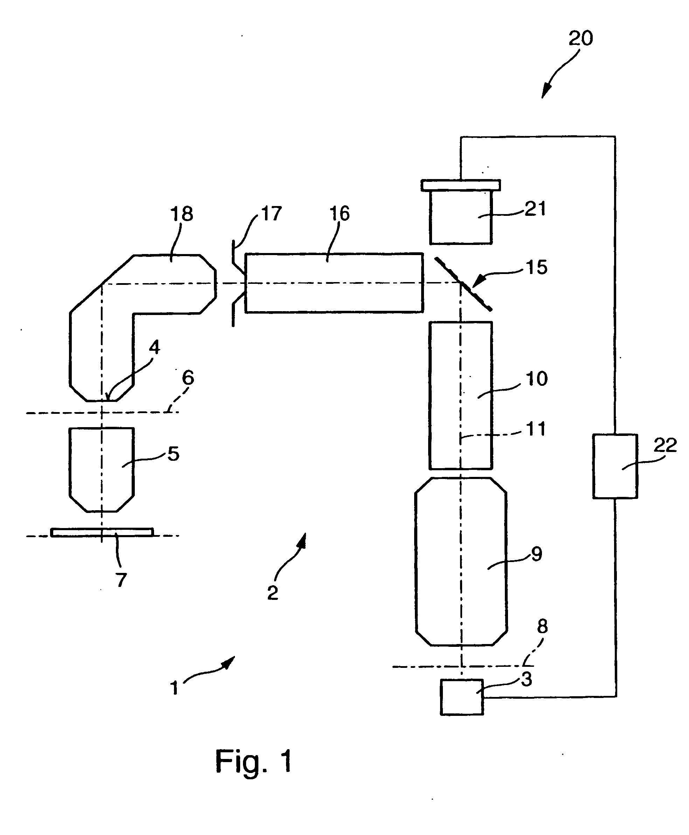

In Fig. 1 ist beispielhaft eine Projektionsbelichtungsanlage 1 für die mikrolithographische Herstellung von integrierten Schaltkreisen oder anderen feinstrukturierten Bauelementen bei Auflösungen bis zu Bruchteilen von 1µm gezeigt. Die Anlage umfasst ein Beleuchtungssystem 2, das eine Lichtquelle 3 und einen Lichtaustritt 4 hat und dazu dient, eine in der Objektebene eines Projektionsobjektives 5 angeordnete Maske 6 gleichmäßig und scharf umrandet in einer an die optischen Eigenschaften des Projektionsobjektives 5 angepaßten Weise zu beleuchten. Das Projektionsobjektiv 5 dient dazu, das auf dem Retikel 6 vorhandene Muster in die Bildebene des Projektions-objektives abzubilden, in dem sich als Substrat ein Halbleiterwafer 7 befindet, der mit einer lichtempfindlichen Schicht (Photoresist) beschichtet ist.

Als Lichtquelle 3 des Beleuchtungssystemes 2 kann ein Laser dienen, beispielsweise ein im tiefen Ultraviolettbereich (DUV) gebräuchlicher Excimer-Laser mit einer Arbeitswellenlänge von 248nm, 193nm oder 157nm. Es kann sich auch um eine mit einem elliptischen Spiegel ausgestattete Quecksilberdampflampe zur Erzeugung einer Arbeitswellenlänge von 365nm handeln. Der von der Lichtquelle bereitgestellte Lichtstrahl gelangt durch einen Verschluß 8 in ein Linsensystem 9, welches der Einkopplung der Strahlung in einen nachgeschalteten Lichtintegrator 10 in Form eines aus transparentem Material bestehenden Stabes dient. Das Licht wird innerhalb des auch als Lichtmischelement bezeichneten Lichtintegrators 10 durch mehrfache innere Reflexion gemischt und tritt aus dem Lichtintegrator weitgehend homogenisiert aus.

Hinter der Austrittsfläche des Lichtintegrators ist in einem Anstellwinkel von 45° zur optischen Achse 11 eine Ausführungsform eines erfindungsgemäßen Strahlteilers 15 angeordnet. Dieser dient als Umlenkspiegel, der das aus dem Lichtintegrator 10 kommende Licht um 90° in Richtung eines weiteren, stabförmigen Lichtintegrators 16 umlenkt, an dessen Austritt sich eine interne Retikel-Maskierungseinrichtung (REMA) 17 befindet. Eine mit einem Umlenkspiegel ausgestattete Optik 18 bildet das REMA dann in die Objektebene des Projektionsobjektives 5 ab, in der das Retikel 6 angeordnet ist.

Bei einer derartigen mikrolithographischen Projektionsbelichtungsanlage ist es wichtig, dass die Lichtmenge, die auf die lichtempfindliche Schicht des Substrates 7 trifft, hochgenau bekannt ist und gegebenenfalls auf einen vorbestimmten Wert eingestellt werden kann. Diesem Zweck dient ein in das Beleuchtungssystem 2 integriertes Strahlungsmeßsystem 20. Dieses umfasst einen lichtempfindlichen Energiesensor 21, der in Verlängerung der optischen Achse 11 hinter dem Strahlteiler 15 so angeordnet ist, dass ein gewisser Anteil des von der Lichtquelle 3 kommenden Lichtes nach Durchtritt durch den Strahlteiler 15 auf den Sensor 21 fällt. Dieser ist an eine Steuereinrichtung 22 angeschlossen, mit der die Abstrahlleistung der Lichtquelle 3 in Abhängigkeit von der durch den Sensor 21 gemessenen Lichtenergie gesteuert werden kann. Es ist erkennbar, dass es zu einer exakten Steuerung des Absolutwertes der auf das Substrat 7 treffenden Strahlung wichtig ist, den Transmissionsgrad des teildurchlässigen Umlenkspiegels 15 genau zu kennen.

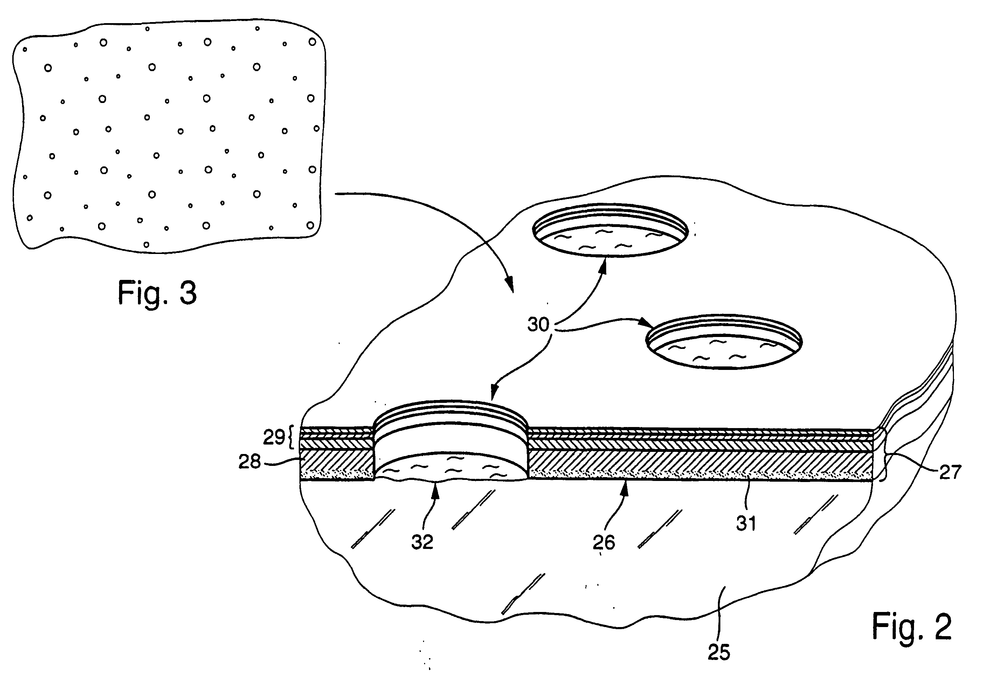

Anhand der Figuren 2 und 3 wird nun der Aufbau des geometrischen Strahlteilers 15 näher erläutert. Der als Dosimetriespiegel dienende Strahlteiler 15 hat ein Substrat 25 aus einem für das verwendete Licht transparenten Material, insbesondere aus synthetischem Quarzglas oder Calciumfluorid. Das Substrat kann z.B. die Form einer planparallelen Platte oder die Form eines Prismas haben. Auf eine ebene Oberfläche 26 des Substrates ist in einem Aufdampfprozeß eine dünne Reflexbeschichtung 27 aufgebracht. Diese besteht im wesentlichen aus einer direkt auf das Substrat 25 aufgedampften Metallschicht 28 aus Aluminium und einer auf die Aluminiumschicht aufgedampften, dielektrischen Reflexionsverstärkungsschicht 29, welche als Mehrfachschichtsystem mit mehreren Schichten aus abwechselnd hochbrechendem und niedrigbrechendem dielektrischen Material ausgebildet ist.

Eine Besonderheit besteht darin, dass das Aluminium mit anfänglich niedriger Aufdampfrate aufgebracht wird, die langsam linear gesteigert wird. Die Eigenschaft, die zu schlechtem Ultraviolett-Reflexionsvermögen beiträgt, nämlich die teilweise Oxidation des Aluminiumdampfes, kann nämlich bei niedrigen Aufdampfraten auch störende Restgasmoleküle binden und hierdurch einen Pumpeffekt erzeugen. Eine Verspiegelung hoher Güte, beispielsweise mit weitgehend oxidationsfreiem Aluminium, wird dann nach "Abpumpen" von Restverunreinigungen und deren Abscheidung in tieferen Lagen der Metallschicht in den obersten, mit relativ hohen Aufdampfraten aufgebrachten Moleküllagen der Metallschicht erreicht. Nur diese obersten Lagen tragen bei einem Vorderflächenspiegel zur Reflexion bei, da die Eindringtiefe der reflektierten Strahlung bei bevorzugten Anwendungen im Ultraviolettbereich nur wenige Nanometer beträgt. Erfindungsgemäße Metallschichten, insbesondere aus Aluminium, können gegebenenfalls an einem Reinheitsgradienten senkrecht zur Schicht erkannt werden, wobei in Substratnähe oxidische Einschlüsse 31 möglich sind und nahe der reflektierenden Oberfläche praktisch verunreinigungsfreies Metallmaterial vorliegt.

Die reflektierende Beschichtung 27 ist so ausgelegt, das sie praktisch lichtundurchlässig für das auftreffende Licht ist, was zum einen durch ausreichende Schichtdicken der Aluminiumschicht von beispielsweise zwischen 50nm und 100nm und zum anderen durch die über Interferenzeffekte bewirkte Reflektivität der dielektrischen Mehrfachschicht 28 sichergestellt ist. Zur Einstellung eines genau definierten Transmissionsgrades des Strahlteilers ist die Reflexschicht an vielen Stellen durch kleine Löcher 30 durchbrochen, die statistisch (Fig. 3) über die reflektierende Oberfläche verteilt sind. Um beispielsweise einen Transmissionsgrad zwischen 0,5% und 1,5% einzustellen, sind Löcher mit typischen mittleren Durchmessern zwischen ca. 40µ und ca. 60µ vogesehen, deren mittlere Abstände zwischen ca. 0,5mm und ca. 1mm liegen.

Die Lochstruktur ist nach Fertigstellung der Reflexbeschichtung 27 durch Laserbearbeitung mit einem gepulsten Laser (Nd:YAG) mit einer Laserwellenlänge von 1064nm hergestellt worden. Dabei wurden für jedes Loch mehrere Pulse eingestrahlt, wobei ein erster Puls im wesentlichen das Loch in der Beschichtung erzeugt und ein zweiter, nachfolgender Laserpuls eine Reinigung des Loches von Rückständen des ersten Laserpulses bewirkt. Bei der gewählten Laserwellenlänge zeigt das Schichtmaterial, insbesondere die Metallschicht 28, ausreichend hohe Absorption, so dass bei geeigneter Pulsenergie das Schichtmaterial in einen etwa kreisförmigen Bereich wohldefinierter Größe verdampft. Bei diesem Prozeß wird i.d.R. die Substratoberfläche 26 im Bereich des Lochgrundes 32 geringfügig aufgeraut, wodurch ein vorteilhafter Lichtstreueffekt im Lochbereich erzeugt wird.

Die Laserbearbeitung erzeugt Löcher, deren Einzeltransmission besonders aufgrund unvermeidbarer Durchmesserstreuungen eine gewisse Streuung aufweist. Dies erschwert eine genaue Einstellung der Gesamttransmission des Strahlteilers, wenn in einem einzigen Schritt eine vorberechnete Anzahl von Löchern erzeugt werden würde. Vorzugsweise wird die Lochstruktur daher in mehreren Stufen erzeugt. Hierbei kann z.B. in einem ersten Schritt ein Transmissions-Sollwert $T_{SOLL}$ eingestellt werden, der deutlich unterhalb der angestrebten Gesamttransmission, beispielsweise bei ca. 80% dieser Gesamttransmission liegt. Die im ersten Schritt erzielte Transmission wird gemessen (Transmissions-Istwert $T_{IST}$) und mit der angestrebten Zieltransmission verglichen. Aus der Differenz wird die Anzahl noch zu erzeugender Löcher berechnet und anschließend in die Reflexbeschichtung eingebracht. Da im zweiten Schritt nur noch vergleichsweise wenig Löcher erzeugt werden müssen, ist auch der durch diesen Schritt erzeugte Maximalfehler der Transmission relativ gering, so dass schon bei einem zweistufigen Verfahren der Absolutwert der Zieltransmission, beispielsweise 1%, bis auf einen geringen Fehler von beispielsweise 15%, bezogen auf diesen Absolutwert, einstellbar ist. Dies wird anhand eines Beispiels im folgenden näher erläutert.

Bei der erwähnten Strukturierung mit gepulstem YAG-Laser ist beispielsweise eine Reproduzierbarkeit der Transmission von ca. 17% relativ zu einem Absolutwert erzielbar. Durch diese große Streuung werden bei einstufigen Prozessen vertretbare, aber geringe Gutausbeuten erzielt, weil ein Teil der Strahlteiler Transmissionsgrade außerhalb der Spezifikation aufweist. Die Gutausbeute lässt sich ohne Veränderung an der kostengünstigen Lasertechnik durch einen mehrstufigen Prozeß deutlich erhöhen. Ausgehend von der Reproduzierbarkeit der Transmission (± 17%) kann beispielsweise in der ersten Stufe ein Zieltransmission von 0,83% angestrebt werden, so dass praktisch kein Strahlteiler nach der ersten Stufe eine über der Zieltransmission liegende Transmission aufweist. Nach Vermessen der im ersten Schritt erzielten Transmission lässt sich die Anzahl k der zusätzlich notwendigen Löcher berechnen aus

$$k=4*(T_{SOLL} - T_{IST})*x*y/(D^2*\pi*t)$$

wobei x und y die Kantenlängen einer rechtwinkligen, zu durchlöchernden Fläche und D der Durchmesser eines Loches mit Transmissionsgrad t ist.

Die stufenweise Korrektur der Anzahl notweniger Löcher kann durch in-situ Messungen der Transmission bis auf die Erzeugung eines einzelnen Loches herabgebrochen werden. Die erreichbare Reproduzierbarkeit der Transmission ist damit nur durch die Transmission eines einzelnen Loches begrenzt. Benötigt man z.B. für ein Feld von 159 x 100 mm 52000 Löcher mit μ Durchmesser für den Transmissionszielwert 1%, so trägt jedes Loch ca. 0,00002% zur Zieltransmission bei; dies ist auch die theoretische Obergrenze der Reproduzierbarkeit.

Da die Gesamtzahl der letztendlich zu erzeugenden Löcher abhängig vom Ergebnis der ersten Verfahrensstufe ist, ist ein Gitteraufbau der endgültigen Lochstruktur, d.h. eine durchgängig regelmäßige Lochanordnung nicht möglich. Unter anderem aus diesem Grund ist eine Nichtgitter-Struktur bevorzugt, die so erzeugt werden muß, dass die Transmission des Bauteiles nahezu ortsunabhängig vom Ort auf der Strahlteilerfläche bleibt. Hierzu können beispielsweise über zwei voneinander unabhängige Zufallsgeneratoren Koordinatenpaare erzeugt werden, die ein auf der Strahlteilerfläche statistisch verteiltes Lochmuster erzeugen, wie es in Fig. 3 gezeigt ist. Ein großer Vorteil des statistischen Lochmusters ist es, dass es sich beliebig durch weitere statistisch verteilte Löcher ergänzen lässt, um in gegebenenfalls kleinen Schritten eine gewünschte Endtransmission einzustellen.

Die reflektierende Beschichtung 27 hat bei einer Ausführungsform über einen großen Einfallswinkelbereich von ca. 45° ± 12° einen hohen Reflexionsgrad R von typischerweise größer als ca. 95%. Diese weitgehende Unabhängigkeit des Reflexionsgrades vom Einfallswinkel ist günstig zur Aufrechterhaltung der Telezentrie des Beleuchtungssystems. Vorteilhaft hierfür ist es, für die Metallschicht 28 Aluminium zu verwenden, das eine große, spektrale Unabhängigkeit der Reflektivität vom Einfallswinkel hat. Die Aluminiumschicht kann gegebenenfalls die äußere, reflektierende Lage der Beschichtung bilden. Bevorzugt ist jedoch die in Fig. 2 schematisch gezeigte Anordnung einer dielektrischen Reflexionsverstärkungsschicht 29 auf der Aluminiumschicht, wodurch sich über einen großen Inzidenzwinkelbereich hohe Reflexionsgrade erreichen lassen.

Ein Beispiel einer bevorzugten Ausführungsform einer Reflexbeschichtung hat auf der Aluminiumschicht ein dielektrisches Mehrschichtsystem aus abwechselnd hochbrechenden (H) und relativ dazu niedrigbrechendem (L) Material und zeichnet sich durch eine geringe Schichtzahl sowie ein spektral breites Stopband, d.h. einen breiten Wellenlängenbereich hoher Reflexionswirkung um die Arbeitswellenlänge λ aus. Das Basis-Schichtdesign ist mit folgender Kurznotation charakterisierbar:

Al|a*0,25L|(0,25H|0,25L)^x|0,75H|0,25L|0,5H.

Bei dieser Notation bezeichnet Al die Aluminiumschicht, ein senkrechter Strich (l) eine Grenzfläche zwischen Schichten und die Angabe 0,25L die Schichtdicke eines niedrigbrechenden Materials in Bruchteilen der Arbeitswellenlänge, hier also eine λ/4-Schicht. Der Faktor a liegt nahe bei 1 und ist vorzugsweise etwas kleiner als 1, beispielsweise zwischen 0,8 und 1. Der Exponent x bezeichnet die Anzahl von Wiederholungen eines λ/4-Schichtenpaares aus hochbrechendem und niedrigbrechendem Material und hat bevorzugt den Wert x=2.

Eine Besonderheit dieses Designs ist die abschließende λ/2-Schicht aus hochbrechendem Material, die wesentlich für die Verbreiterung des Stopbandes durch eine achromatisierende Wirkung verantwortlich ist. Weiterhin kennzeichnend ist eine dicke hochbrechende Schicht mit Nominalschichtdicke ¾ λ im Anschluß an die Paare von λ/4-Schichten. Für eine Optimierung des Verlaufs des Reflexionsgrades R(λ) über die Wellenlänge können die tatsächlichen Schichtdicken geringfügig von diesem Basisdesign abweichen. Ein bevorzugtes Design ist danach wie folgt charakterisiert:

Al|0,19L|0,28H|0,25L|0,28H|0,25L|0,84H|0,26L|0,57H|.

Die Anpassung der Schichtdicken an den hier bevorzugten Hauptwinkel der Reflexion von 45° erfolgt durch Multiplikation der Schichtdicken mit dem Faktor 1/cosφ', wobei φ' der Durchtrittswinkel des Lichtes innerhalb der Schicht (gem. Snellius-Gesetz) ist. Die an den Hauptwinkel 45° angepassten Schichtdicken sind dann:

Al|0,22L|0,30H|0,28L|0,30H|0,28L|0,89H|0,30L|0,60H|
.

Für eine Arbeitswellenlänge λ=365nm (Quecksilber i-Linie) ergibt dies folgende geometrische Schichtdicken (in nm):

Al|54,5L|57,0H|70,4L|57,8H|68,2L|170,2H|73,6L|114,8H|.

Für Arbeitswellenlängen λ> ca. 230nm, insbesondere also für 248nm oder 365nm, wird vorzugsweise als hochbrechendes Material Hafniumdioxid und als niedrigbrechendes Material Siliziumdioxid verwendet. Auch andere Materialien sind bei entsprechender Anpassung der Schichtdicken an deren Brechungsindizes im obigen Basisdesign verwendbar. Als alternative Materialien kommen alle Oxide und Fluoride in Frage, deren Absorption geringer ist als der im Mehrschichtstapel (Stack) erzeugte Reflexionshub. Vorzugsweise werden im Nutzwellenlängenbereich absorptionsfreie Materialien verwendet, beispielsweise $MgF_2$ als niedrigbrechendes oder $LaF_3$ oder $ThF_4$ als hochbrechendes Material, bei 365 auch $Ta_2O_5$. Idealerweise haben diese Materialien bei der Strukturierungswellenlänge (z.B. 1064nm) eine hohe Absorption.

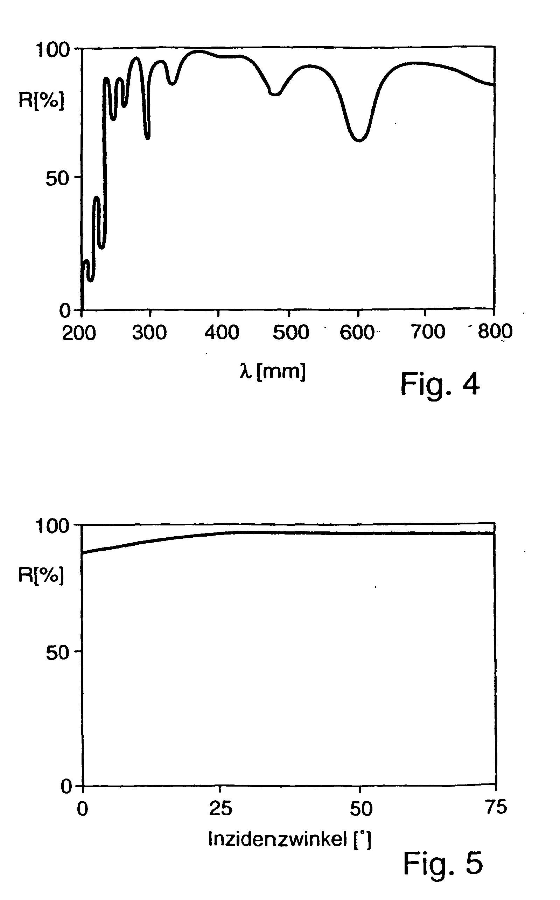

Anhand der Figuren 4 und 5 sind wesentliche optische Eigen-schaften dieses Designs erkennbar, nämlich in Fig. 4 der hohe Reflexionsgrad R der Beschichtung in einem breiten Stopband um die Arbeitswellenlänge λ=365nm und in Fig. 5 die nur geringe Abhängigkeit des hohen Reflexionsgrades vom Inzidenzwinkel.

Ein für eine Arbeitswellenlänge von 248nm optimiertes Design mit Hafniumdioxid/Siliciumdioxid-Wechselschichten für den ent-sprechenden Einfallswinkelbereich ist wie folgt charakterisiert:

Al|51,5H|50,7L|32,7H|50,7L|32,7H|52,1L|18,3H|.

Hier ist die der Aluminiumschicht folgende erste dielektrische Schicht aus niedrigbrechendem Material und das Schichtsystem schließt mit einer hochbrechenden Schicht mit einer Schicht-dicke deutlich kleiner als λ/4 ab.

Ein auf den gleichen Materialien basierendes Schichtsystem, das in einem Wellenlängenbereich zwischen ca. 230nm und ca. 370nm im oben angegebenen Einfallswinkelbereich hohe Reflexionsgrade >92% aufweist, ist wie folgt gekennzeichnet:

Al|39,4L|36,3H|54,7L|36,3H|36,1L|8,2H|60,7L|28,6H|.

Auch folgendes Design ist möglich, um für den gleichen Einfallswinkelbereich hohe Reflexionsgrade > 92° zu erhalten:

Al|39,6L|36,2H|53,6L|37,3H|27,5L|15,1H|58,0L|37,2H|34,5L|
11,2H|54,1L|90,0H|70,9L|

Die Schichtdicken können jeweils bis zu 5% von den angegebenen, optimalen Schichtdicken abweichen, ohne die optischen Eigenschaften des Schichtsystems wesentlich zu verschlechtern.

Für Arbeitswellenlängen deutlich unterhalb 230nm, insbesondere für λ=193nm, haben sich Schichtsysteme mit fluoridischen niedrigbrechenden und hochbrechenden Materialien bewährt. Besonders vorteilhaft sind Schichtsysteme, bei denen als niedrigbrechendes Material Magnesiumfluorid ($MgF_2$) und als hochbrechendes Material Thoriumfluorid ($ThF_4$) verwendet wird.

Es hat sich gezeigt, dass es für einen großen Einfallswinkelbereich (45°± 12°) für die Erzielung hoher Reflexionsgrade oberhalb ca. 89% oder 90% schon ausreicht, die Aluminiumschicht mit einer Einzelschicht aus hochbrechendem Material, insbesondere Thoriumfluorid zu bedecken, wobei die optimale geometrische Schichtdicke hier ca. 53nm beträgt.

Höhere Reflexionsgrade lassen sich auf Basis von $MgF_2$/$ThF_4$-Wechselschichten schon mit wenigen Schichten, typischerweise mit weniger als sieben Schichten erreichen. Ein System mit Reflexionsgrad R > 92% ist wie folgt gekennzeichnet:

Al|24,0L|36,1H|40,8L|36,1H|41,0L|34,0H|.

Ein Wechselschichtsystem mit nur vier Schichten und Reflexionsgrad R > 91 % über den gesamten Einfallswinkelbereich ist wie folgt aufgebaut:

Al|23,0L|36,1H|39,3L|36,4H|.

Es ist auch möglich, dass die erste, direkt auf das Aluminium aufgebrachte dielektrische Schicht aus hochbrechendem Material besteht. Hier ist beispielhaft folgendes Schichtsystem mit nur fünf Schichten zu nennen:

Al|54,7H|38,3L|36,3H|39,4L|30,0H|.

Diese Schichtsysteme zeichnen sich durch besonders geringe Schichtzahl aus, was sich günstig auf die Laserbeständigkeit der Verspiegelungsbeschichtungen im Dauerbetrieb auswirkt. Die Schichtsysteme sind tolerant gegen Schwankungen der Herstellungsbedingungen, so dass sich Schichtdickenabweichungen von den angegebenen optimalen Designs um ca. ± 5% nur unwesentlich auf die optischen Eigenschaften auswirken.

Es kann auch gewünscht sein, dass ein Spiegel nur für einen sehr schmalen Einfallswinkelbereich einen hohen Reflexionsgrad aufweist. Derartige Spiegel sind prinzipiell als schmalbandige Filter in einem Strahlengang einsetzbar. Ein für eine Arbeitswellenlänge von 193nm ausgelegtes Schichtsystem, das nur in einem schmalen Einfallswinkelbereich von (45°± 1 °) eine hohen Reflexionsgrad, typischerweise größer als 95%, aufweist, ist wie folgt charakterisierbar:

Al|(0,25<d<0,5)H|(0,25L|0,25H)$^x$|0,5|,

wobei hier die Schichtdicken für hochbrechendes und niedrig-brechendes Material in Bruchteilen der Arbeitswellenlänge angegeben sind und d eine Schichtdicke in Bruchteilen der Arbeitswellenlänge ist. Der Exponent x liegt bevorzugt bei x=9, kann aber auch generell im Bereich darunter oder darüber liegen. Für ein bevorzugtes Schichtsystem mit Thoriumfluorid als hochbrechendem und Magnesiumfluorid als niedrigbrechendem Material entspricht dieses Design folgenden geometrischen Schichtdicken:

$Al|50,3H|(38,6L|33,3H)^9|77,2L|$.

Alle im Zusammenhang mit den Ausführungsbeispielen genannten Reflexionsbeschichtungen sind besonders vorteilhaft in Verbindung mit der durch Laserbearbeitung erzeugten Lochstruktur einsetzbar, also auf erfindungsgemäßen Strahlungsteilern. Selbstverständlich sind die Schichtsysteme auch bei normalen Reflexionsbeschichtungen ohne Lochstruktur vorteilhaft verwendbar.

Die geringe Abhängigkeit des Reflexionsgrades vom Einfallswinkel der einfallenden Strahlung bei den oben beschriebenen Beschichtungen ist auch insofern vorteilhaft, als derartige Beschichtungen auch auf gekrümmten Oberflächen vorteilhaft einsetzbar sind, beispielsweise bei der Verspiegelung von abbildenden Spiegeln in katadioptrischen Projektionsobjektiven für die Mikrolithographie.

**Patentansprüche**

1.  Verfahren zur Herstellung eines geometrischen Strahlteilers mit folgenden Schritten:

    Beschichtung einer Oberfläche eines aus transparentem Material bestehenden Substrats mit einer Reflexbeschichtung, die mindestens eine Metallschicht enthält;
    Erzeugung einer Lochstruktur mit einer Vielzahl von transparenten Löchern in der Reflexbeschichtung, **dadurch gekennzeichnet, dass** die Löcher der Lochstruktur durch Läserbearbeitung erzeugt werden und dass die Lochstruktur eine Nicht-Gitterstruktur mit einer statistischen Verteilung von Löchern ist, bei der die Flächenkoordinaten der Löcher nach dem Zufallsprinzip erzeugt werden.

2.  Verfahren nach Anspruch 1, **dadurch gekennzeichnet, dass** zur Erzeugung eines Loches ein erster und mindestens ein zweiter Laserpuls eingestrahlt werden, wobei die Laserpulse vorzugsweise im wesentlichen die gleiche Leistungsdichte und Dauer haben.

3.  Verfahren nach einem der vorhergehenden Ansprüche, **dadurch gekennzeichnet, dass** zur Herstellung eines Strahlteilers mit einem vorgegebenen Transmissions-Sollwert folgende Schritte durchgeführt werden:

    Erzeugung einer Verteilung von Löchern derart, dass die Gesamttransmission des Strahlteilers geringer ist als der Transmissions-Sollwert, wobei die Löcher der Verteilung statistisch verteilt mit Flächenkoordinaten nach dem Zufallsprinzip erzeugt werden.
    Messung der Transmission des Strahlteilers zur Bestimmung eines Transmission-Istwertes;
    Erzeugung weiterer Löcher zur Erhöhung der Transmission des Strahlteilers in Abhängigkeit von dem Transmission-Istwert, wobei bei der Erzeugung weiterer Löcher die weiteren Löcher mit statistischer Verteilung mit Flächenkooridinaten nach dem Zufallsprinzip ergänzt werden und/oder wobei vorzugsweise nach der Messung eines Transmission-Istwertes eine Berechnung der Anzahl noch zu ergänzender Löcher auf Basis der Differenz zwischen dem Transmissions-Sollwert und dem Transmissions-Istwert durchgeführt wird und die Ergänzung weiterer Löcher in Abhängigkeit vom Ergebnis dieser Berechnung erfolgt.

4.  Verfahren nach einem der vorhergehenden Ansprüche mit folgenden Schritten:

    Sequentielle Erzeugung einer Vielzahl von verteilten Löchern, wobei die Löcher der Verteilung statistisch verteilt nach dem Zufallsprinzip erzeugt werden;
    Messung der Transmission des Strahlteilers während der Erzeugung der Löcher (in-situ Messung) zur Ermittlung von aktuellen Transmissionswerten;
    Beendigung der Erzeugung von Löchern, wenn der aktuelle Transmissionswert im wesentlichen dem Transmissions-Sollwert entspricht.

5.  Verfahren nach einem der vorhergehenden Ansprüche, **dadurch gekennzeichnet, dass** das Material der Metallschicht, insbesondere Aluminium, mit einer, vorzugsweise linear, ansteigenden Aufdampfrate aufgedampft wird, wobei in einer Anfangsphase einer Aufdampfung die Aufdampfrate derart gering gewählt wird, dass durch das aufgedampfte Material eine Getterwirkung auf in der Aufdampfatmosphäre befindliche Restverunreinigungen ausübbar ist.

6.  Geometrischer Strahlteiler, insbesondere Dosimetriespiegel (15) für ein Beleuchtungssystem (2) einer Mikrolithographie-Projektionsbelichtungsanlage (1), der Strahlteiler mit:

    einem Substrat (25) aus transparentem Material;
    einer auf einer Oberfläche (26) des Substrats angeordneten Reflexbeschichtung (27), die mindestens eine Metallschicht (28) enthält; und

einer in der Reflexbeschichtung ausgebildeten Lochstruktur mit einer Vielzahl von transparenten Löchern (30), **dadurch gekennzeichnet**, das die Löcher durch Laserbearbeitung in die Reflexbeschichtung eingebracht sind, und dass die Lochstruktur eine nicht Nicht-Gitterstruktur mit statistischer Verteilung von Löchern (30) ist, bei der die Flächenkoordinaten der Löcher nach dem Zufallsprinzip erzeugt werden.

7. Strahlteiler nach Anspruch 6, **dadurch gekennzeichnet, dass** die Löcher einen mittleren Durchmesser zwischen ca. 30µm und ca. 1 00µm haben, insbesondere zwischen ca. 40µm und ca. 60µm und/oder dass die Löcher einen mittleren Abstand zueinander aufweisen, der im Bereich zwischen ca. 0,5mm und ca. 1mm liegt und/oder dass der Strahlteiler eine Gesamttransmission von weniger als 5% aufweist, vorzugsweise von weniger als 3%, insbesondere von ca. 1 %, und/oder dass die Metallschicht (28) außerhalb der Löcher (30) im wesentlichen lichtundurchlässig ist.

8. Strahlteiler nach einem der Ansprüche 6 oder 7, **dadurch gekennzeichnet, dass** die vorzugsweise im wesentlichen aus Aluminium bestehende Metallschicht (28) senkrecht zur Schichtausdehnung einen Gradienten von, insbesondere oxidischen, Verunreinigungen aufweist, bei dem nahe dem die Metallschicht (28) tragenden Substrat Verunreinigungen vorhanden sind und der Bereich nahe der reflektierenden Oberfläche im wesentlichen frei von Verunreinigungen ist.

9. Strahlteiler nach einem der Ansprüche 6 bis 8, **dadurch gekennzeichnet, dass** auf der Metallschicht (28) eine dielektrische Reflexionsverstärkungsschicht (29) aufgebracht ist, die vorzugsweise als Mehrschichtsystem mit mehreren Schichten aus abwechselnd hochbrechendem und niedrigbrechendem dielektrischen Material ausgebildet ist.

10. Strahlteiler nach einem der Ansprüche 6 bis 9, **dadurch gekennzeichnet, dass** die Reflexbeschichtung (27) mindestens in einem Einfallswinkelbereich von (45°± 1°) einen Reflexionsgrad von mehr als ca. 90% aufweist, vorzugsweise von mehr als ca. 95%, wobei der Einfallswinkelbereich vorzugsweise mindestens (45°± 12°) beträgt.

11. Beleuchtungssystem für eine optische Einrichtung, insbesondere für eine Mikrolithographie-Projektionsbelichtungsanlage, das Beleuchtungssystem mit einer Lichtquelle (3) und einem Lichtaustritt (4), wobei zwischen Lichtquelle und Lichtaustritt mindestens ein geometrischer Strahlteiler (15) nach einem des Ansprüche 6-10 zur Auskopplung eines Bruchteils des von der Lichtquelle (3) kommenden Lichtes angeordnet ist.

12. Beleuchtungssystem nach Anspruch 11, **dadurch gekennzeichnet, dass** sie mindestens einen Energiesensor (21) umfasst, der in Bezug auf den Strahlteiler (15) derart angeordnet ist, dass durch den Energiensensor die Intensität von durch den Strahlteiler transmittierter Strahlung erfassbar ist.

**Claims**

1. Method for production of a geometric beam splitter having the following steps:

   coating of a surface of a substrate, which is composed of transparent material, with a reflective coating which contains at least one metal layer;
   production of a hole structure with a large number of transparent holes in the reflective coating,

   **characterized**
   **in that** the holes are produced in the hole structure by laser processing, and in that the hole structure is a structure which is not a grating with a statistical distribution of holes, in which the area coordinates of the holes are produced on the random-number principle.

2. Method according to Claim 1, **characterized in that** a first and at least one second laser pulse are applied in order to produce a hole, with the laser pulses preferably having essentially the same power density and duration.

3. Method according to one of the preceding claims, **characterized in that** the following steps are carried out in order to produce a beam splitter with a predetermined nominal transmission value:

   production of a distribution of holes in such a way that the overall transmission of the beam splitter is less than the nominal transmission value, with the holes in the distribution being produced such that they are statistically distributed with area coordinates based on the random number principle,
   measurement of the transmission of the beam splitter in order to determine an actual transmission value;
   production of further holes in order to increase the transmission of the beam splitter as a function of the actual transmission value, with the further holes, when further holes are produced, being added with a statistical distribu-

9

tion with area coordinates based on the random number principle, and/or with the number of holes still to be added being calculated, preferably after the measurement of an actual transmission value, on the basis of the difference between the nominal transmission value and the actual transmission value, and further holes being added as a function of the result of this calculation.

4. Method according to one of the preceding claims, having the following steps:

sequential production of a large number of distributed holes, with the holes in the distribution being statistically distributed on the basis of the random number principle;
measurement of the transmission of the beam splitter during the production of the holes (in-situ measurement) in order to determine the actual transmission values;
ending of the production of holes when the actual transmission value corresponds essentially to the nominal transmission value.

5. Method according to one of the preceding claims, **characterized in that** the material of the metal layer, in particular aluminium, is vapour-deposited at a vapour-deposition rate which rises, preferably linear, with the vapour-deposition rate being chosen to be low in an initial phase of vapour deposition, such that the vapour-deposited material allows a getter effect to be exerted on residual impurities located in the vapour-deposition atmosphere.

6. Geometric beam splitter, in particular a dosimetry mirror (15) for an illumination system (2) for a micro lithography projection exposure system (1), the beam splitter having:

a substrate (25) composed of transparent material;
a reflective coating (27), which is arranged on one surface (26) of the substrate and contains at least one metal layer (28); and
a hole structure, which is formed in the reflective coating and has a large number of transparent holes (30), **characterized in that** the holes are incorporated in the reflective coating by laser processing, and **in that** the hole structure has a structure which is not in the form of a grating with a statistical distribution of holes (30), in which the area coordinates of the holes are produced on the basis of the random number principle.

7. Beam splitter according to Claim 6 , **characterized**

**in that** the holes have a mean diameter between about 30 µm and about 100 µm, in particular between about 40 µm and about 60 µm, and/or **in that** the holes are at a mean distance from one another which is in the range between about 0.5 mm and about 1 mm and/or **in that** the beam splitter has an overall transmission of less than 5%, preferably of less than 3% and in particular of about 1%, and/or **in that** the metal layer (28) is essentially opaque away from the holes (30).

8. Beam splitter according to one of Claims 6 or 7, **characterized in that** the metal layer (28), which is preferably essentially composed of aluminium, has a gradient of, in particular oxidic, impurities at right angles to the layer extent, in which impurities are present close to the substrate in which the metal layer (28) is fitted, and the area close to the reflective surface is essentially free of impurities.

9. Beam splitter according to one of Claims 6 to 8, **characterized in that** a dielectric reflection increasing layer (29) is applied to the metal layer (28) and is preferably in the form of a multilayer system with a plurality of layers composed of dielectric material which alternately has a high refractive index and a low refractive index.

10. Beam splitter according to one of Claims 6 to 9, **characterized in that** the reflective coating (27) has a reflection level of more than about 90% at least in an incidence angle range of ($45° \pm 1°$), preferably of more than about 95%, with the incidence angle range preferably being at least ($45° \pm 12°$).

11. Illumination system for an optical device, in particular for a micro lithography projection exposure system, which illumination system has a light source (3) and a light outlet (4), with at least one geometric beam splitter (15) according to one of Claims 6-10 being arranged between the light source and the light outlet in order to emit a fraction of the light coming from the light source (3).

12. Illumination system according to Claim 11, **characterized in that** it has at least one energy sensor (21), which is arranged with respect to the beam splitter (15) in such a way that the energy sensor can detect the intensity of radiation transmitted through the beam splitter.

**Revendications**

1. Procédé en vue de la fabrication d'un diviseur de faisceau géométrique avec les étapes suivantes:

revêtement d'une surface d'un substrat constitué d'un matériau transparent à l'aide d'un revêtement de réflexion, qui contient au moins une couche métallique;

production d'une structure à trous ayant une multitude de trous transparents dans le revêtement de réflexion, **caractérisé en ce que** les trous de la structure à trous sont produits par traitement au laser et **en ce que** la structure à trous est une structure non réseau ayant un répartition statistique de trous, pour laquelle les coordonnées de surface des trous sont produites conformément au principe du hasard.

2. Procédé selon la revendication 1, **caractérisé en ce qu'**en vue de la production d'un trou on irradie à l'aide d'une première et d'au moins une deuxième pulsation de laser, les pulsations de laser ayant pour l'essentiel la même densité de puissance et la même durée.

3. Procédé selon l'une quelconque des revendications précédentes, **caractérisé en ce qu'**en vue de la fabrication d'un diviseur de faisceau ayant une valeur de consigne de transmission prédéterminée, on effectue les étapes suivantes:

production d'une répartition de trous de telle sorte que la transmission globale du diviseur de faisceau soit plus faible que la valeur de consigne de transmission, les trous de la répartition étant produits conformément au principe du hasard avec des coordonnées de surface réparties de manière statistique;

mesure de la transmission du diviseur de faisceau en vue de la détermination d'une valeur effective de transmission;

production de trous supplémentaires en vue de l'augmentation de la transmission du diviseur de faisceau en fonction de la valeur effective de transmission, lors de la production de trous supplémentaires, les trous supplémentaires étant complétés avec une répartition statistique avec des coordonnées de surface conformément au principe du hasard, en cas de production de trous supplémentaires, et/ou, de préférence, après la mesure d'une valeur effective de transmission, un calcul du nombre de trous encore à compléter étant effectué sur la base de la différence entre la valeur de consigne de transmission et la valeur effective de transmission et le complément de trous supplémentaires se faisant en fonction du résultat de ce calcul.

4. Procédé selon l'une quelconque des revendications précédentes avec les étapes suivantes:

production séquentielle d'une multiplicité de trous répartis, les trous de la répartition étant produits avec une distribution statistique conformément au principe du hasard;

mesure de la transmission du diviseur de faisceau pendant la production des trous (mesure in situ) en vue de la détermination de valeurs de transmission actuelles;

achèvement de la production des trous, lorsque la valeur de transmission actuelle correspond pour l'essentiel à la valeur de consigne de transmission.

5. Procédé selon l'une quelconque des revendications précédentes, **caractérisé en ce que** le matériau de la couche métallique, en particulier l'aluminium est vaporisé avec une vitesse de vaporisation croissante, de préférence, linéaire, la vitesse de vaporisation, au cours de la phase de début de la vaporisation, étant choisie suffisamment faible pour que, grâce au matériau vaporisé, l'on puisse exercer une action de getters sur les impuretés résiduelles qui se trouvent dans l'atmosphère de vaporisation.

6. Diviseur de faisceau géométrique, en particulier miroir de dosimétrie (15) pour un système d'illumination (2) d'une installation d'illumination de projection en micro lithographie (1), le diviseur de faisceau étant pourvu:

d'un substrat (25) en matériau transparent;
d'un revêtement de réflexion (27) disposé sur une surface (26) du substrat, qui contient au moins une couche métallique (28); et
d'une structure à trous, formée dans le revêtement de réflexion, ayant une multitude de trous transparents (30), **caractérisé en ce que** les trous sont introduits par traitement au laser dans le revêtement de réflexion et **en ce que** la structure à trous est une structure non réseau avec une répartition statistique de trous (30), pour laquelle les coordonnées de surface des trous sont produits conformément au principe du hasard.

7. Diviseur de faisceau selon la revendication 6, **caractérisé en ce que** les trous ont un diamètre moyen compris entre environ 30 µm et environ 100 µm, en particulier entre environ 40 µm et environ 60 µm et/ou **en ce que** les trous présentent un écart moyen les uns des autres qui se situe dans le domaine compris entre environ 0,5 mm et environ 1 mm et/ou **en ce que** le diviseur de faisceau présente une transmission globale de moins de 5%, de préférence, de moins de 3%, en particulier d'environ 1%, et/ou **en ce que** la couche métallique (28) n'est pas, pour l'essentiel transparente à l'extérieur des trous (30).

8. Diviseur de faisceau selon l'une quelconque des revendications 6 ou 7, **caractérisé en ce que** la couche métallique (28) constituée, de préférence, pour l'essentiel, d'aluminium, présente, verticalement par rapport à l'extension de la couche, un gradient d'impuretés, en particulier, oxydées, pour lequel, à proximité du substrat portant la couche métallique (28), des impuretés sont présentes et pour lequel le domaine au voisinage de la surface réfléchissante est, pour l'essentiel, exempte d'impuretés.

9. Diviseur de faisceau selon l'une quelconque des revendications 6 à 8, **caractérisé en ce que** l'on applique, sur la couche métallique (28) une couche de renforcement de la réflexion (29), qui est formée, de préférence, en tant que système multicouches ayant plusieurs couches en matériau diélectrique en alternance à indice de réfraction élevé et à indice de réfraction faible.

10. Diviseur de faisceau selon l'une quelconque des revendications 6 à 9, **caractérisé en ce que** le revêtement de réflexion (27) présente au moins, dans un domaine d'angle incident de (45° ± 1°), un degré de réflexion de plus d'environ 90%, de préférence, de plus d'environ 95%, le domaine d'angle incident étant, de préférence, d'au moins (45° ± 12°).

11. Système d'illumination en vue d'un équipement optique, en particulier pour une installation d'illumination de projection en micro lithographie, le système d'illumination ayant une source lumineuse (3) et une sortie de lumière (4), au moins un diviseur de faisceau géométrique (15) étant disposé, selon l'une quelconque des revendications 6 - 10, entre la source lumineuse et la sortie de lumière en vue du découplage d'une fraction de la lumière provenant de la source lumineuse (3).

12. Système d'illumination selon la revendication 11, **caractérisé en ce qu'**elle comprend au moins un détecteur d'énergie (21), qui est disposé par rapport au diviseur de faisceau (15) de manière à ce que l'on puisse déterminer, grâce au détecteur d'énergie, l'intensité du rayonnement transmis par le diviseur de faisceau.

Fig. 1

Fig. 2

27

31

25

26

32

29

28

30

Fig. 3

Fig. 4

Fig. 5